# EUROPÄISCHE PATENTANMELDUNG

(11) **EP 4 138 525 A1**
(43) Veröffentlichungstag der Anmeldung: **22.02.2023**
(21) Anmeldenummer: 21191738.0
(22) Anmeldetag: 17.08.2021
(51) Int. Cl.: H05K 1/18, B32B 3/08, B60Q 3/43, H05K 3/46, H05K 1/02, H05K 3/22, H05K 1/03, H05K 3/00

(54) **VERFAHREN ZUR HERSTELLUNG EINES PANEELS MIT INTEGRIERTER ELEKTRONIK**

(71) Anmelder: Airbus S.A.S., 31707 Blagnac Cedex (FR)
(72) Erfinder: MACHUNZE, Wolfgang, 82024 Taufkirchen (DE); FRIEDBERGER, Alois, 82024 Taufkirchen (DE)
(74) Vertreter: LKGLOBAL Lorenz & Kopf PartG mbB Patentanwälte

(57) **Zusammenfassung**

Es ist ein Verfahren (100) zur Herstellung eines Paneels (10) mit integrierten Leiterbahnen (18) und Elektronikkomponenten (16) gezeigt. Das Paneel (10) umfasst dabei einen Paneelkörper (12), wobei der Paneelkörper (12) insbesondere eine Sandwichstruktur ist, und eine Membran (14). Die Membran (14) ist mit dem Paneelkörper (12) verbunden und weist integrierte Leiterbahnen (18) und Elektronikkomponenten (16) auf. Zu Beginn des Verfahrens (100) ist ein Anbringen (102) der Leiterbahnen (18) und der Elektronikkomponenten (16) auf die Membran (14) vorgesehen. Der darauffolgende Schritt umfasst ein Verbinden (104) der mit den Leiterbahnen (18) und den Elektronikkomponenten (16) bestückten Membran (14) mit dem Paneelkörper (12).

## Beschreibung

### Gebiet der Erfindung

Die Erfindung betrifft ein Verfahren zur Herstellung eines Paneels. Insbesondere betrifft die Erfindung ein Verfahren zur Herstellung eines Paneels mit integrierter Elektronik, welches es ermöglicht, die Elektronik direkt auf eine Membran anzubringen und diese Membran anschließend mit dem Paneelkörper zu verbinden.

### Technischer Hintergrund der Erfindung

Nahezu jegliche Fortbewegungsmittel sind heutzutage mit elektronischen Komponenten für verschiedene Anwendungsfälle ausgestattet. Um diesen elektronischen Komponenten Energie zuzuführen oder über diese Signale auszutauschen sind Leiterbahnen notwendig. Diese Leiterbahnen liegen in der Regel in Form eines Kabelbaums vor. Ein Kabelbaum ist dabei eine, oft konfektionierte, Bündelung einzelner Leitungen, die Signale (Information) oder Arbeitsströme (Energie) übertragen. Die Leitungen werden dabei als Kabelstrang geführt und ummantelt oder durch Schellen, Kabelbinder, Bindegarn oder Schläuche zusammengehalten.

Ferner sind dem Fachmann aus dem Stand der Technik auch Verfahren bekannt in denen die Elektronik gedruckt wird. Gedruckte Elektronik bezeichnet hierbei elektronische Bauelemente, Baugruppen und Anwendungen, wie eben Leiterbahnen die vollständig oder teilweise mittels Druckverfahren hergestellt werden. Anstelle von Druckfarben werden elektronische Funktionsmaterialien, die in flüssiger oder pastöser Form vorliegen, verdruckt.

Aufgrund des meist begrenzten Bauraums verläuft die Elektronik oftmals direkt hinter Verkleidungspaneelen, welche den Fahrgast vor unerwünschten Wechselwirkungen mit der Elektronik schützen sollen.

### Zusammenfassung der Erfindung

Es kann als eine Aufgabe der Erfindung angesehen werden, ein Verfahren bereitzustellen, welches die Integration elektronischer Komponenten in ein Paneel vereinfacht und den Einsatz zusätzlicher Komponenten reduziert.

Es sind ein Verfahren zur Herstellung eines Paneels mit integrierten Leiterbahnen und Elektronikkomponenten, eine Seitenwand umfassend ein erfindungsgemäßes Paneel, sowie ein Luftfahrzeug umfassend eine erfindungsgemäße Seitenwand, gemäß den Merkmalen der unabhängigen Patentansprüche angegeben. Weiterbildungen der Erfindung ergeben sich aus den Unteransprüchen und aus der folgenden Beschreibung.

Gemäß einem ersten Aspekt der Erfindung ist ein Verfahren zur Herstellung eines Paneels mit integrierten Leiterbahnen und Elektronikkomponenten angegeben.

Ein Paneel im Sinne der Erfindung stellt dabei ein flächiges Element welches vorzugsweise als Verkleidungselement eingesetzt wird, insbesondere eine Tafel, zur Wand- oder Deckenverkleidung, dar. Ein Paneel kann dabei eine einzelne Tafel oder eine Vielzahl von Tafeln umfassen.

Das Paneel im Sinne der Erfindung umfasst dabei einen Paneelkörper, wobei der Paneelkörper insbesondere eine Sandwichstruktur umfasst. Diese Sandwichstruktur besteht dabei aus mehreren Schichten, wobei die mehreren Schichten aus unterschiedlichem Material bestehen können. Dabei erfüllen die verschiedenen Schichten diverse Zwecke, beispielsweise Schall- oder Wärmedämmung, Verbesserung der mechanischen Belastbarkeit oder Beständigkeit gegenüber Umwelteinflüssen. Der Kern der Sandwichstruktur kann dabei Polyurethanschaum oder Mineralwolle umfassen. Durch den Verbund der Schichten mit dem schubsteifen Kern ergibt sich für das Sandwichpaneel eine hohe Tragfähigkeit und eine große Steifigkeit.

Ferner weist das Paneel eine Membran auf, wobei die Membran mit dem Paneelkörper verbunden ist.

Eine Membran im Sinne der Erfindung ist dabei eine dünne Struktur mit unterschiedlichen Eigenschaften, die wie eine Haut oder Folie im Verhältnis zu ihrer Dicke eine große flächige Ausdehnung besitzt. Die Membran weist dabei eine Schutzwirkung für den Paneelkörper gegenüber äußeren Einflüssen auf. Funktional stellt die Membran im Sinne der Erfindung somit eine Schutzfolie dar.

Die Membran weist dabei integrierte Leiterbahnen und Elektronikkomponenten auf. Da die Innenauskleidung in der Regel standardmäßig das Aufbringen einer Schutzfolie vorsieht, kann durch die Integration der Leiterbahnen und Elektronikkomponenten auf die Membran (Schutzfolie) eine Einsparung zusätzlicher Komponenten vorgenommen werden.

Leiterbahnen im Sinne der Erfindung sind dabei elektrisch leitende Verbindungen mit zweidimensionalem Verlauf, das heißt in einer Ebene, in der sie eine Leiterbahn- oder Metallisierungsebene ausbilden. Leiterbahnen im Sinne der Erfindung werden zur Verbindung von elektronischen Bauelementen auf Leiterplatten und integrierten Schaltkreisen eingesetzt, das heißt, sie dienen zur Strom- bzw. Spannungsversorgung, Signalübertragung und auch zur Temperaturableitung.

Leiterbahnen im Sinne der Erfindung können dabei anorganisch oder organisch sein. Mögliche metallische Materialien sind dabei beispielsweise Kupfer, Aluminium, Gold oder auch Legierungen hiervon. Es sind aber auch Leiterbahnen aus organischen Materialien wie beispielsweise Kohlenstofffasern denkbar.

Das Verfahren zur Herstellung eines Paneels mit integrierten Leiterbahnen und Elektronikkomponenten weist dabei folgende Schritte auf. Zuerst werden die Leiterbahnen und die Elektronikkomponenten auf die Membran angebracht.

Unter einem Anbringen ist im Sinne der Erfindung jeder Verfahrensschritt zu verstehen, der eine dauerhafte Verbindung zwischen den Leiterbahnen und/oder den Elektronikkomponenten mit der Membran herstellt.

Anschließend wird die Membran mit dem Paneelkörper verbunden. Unter einem Verbinden ist im Sinne der Erfindung jeder Verfahrensschritt zu verstehen, der eine Verbindung zwischen der Membran und dem Paneelkörper ermöglicht. Die Verbindung kann reversibel sein. Die Verbindung kann über die ganze Fläche der Membran oder nur einen Teil der Fläche der Membran vorliegen.

Gemäß einer Ausführungsform der Erfindung sind die integrierten Leiterbahnen und Elektronikkomponenten auf der Innenseite der Membran, somit der dem Paneelkörper zugewandten Seite angebracht.

Gemäß einer weiteren Ausführungsform der Erfindung sind die integrierten Leiterbahnen und Elektronikkomponenten auf der Außenseite der Membran, somit der dem Paneelkörper abgewandten Seite angebracht.

Gemäß einer weiteren Ausführungsform der Erfindung sind die integrierten Leiterbahnen und Elektronikkomponenten innerhalb der Membran angebracht. Insofern die integrierten Leiterbahnen und Elektronikkomponenten innerhalb der Membran angebracht sind, umfasst die Membran zwei Schichten, wobei die integrierten Leiterbahnen und Elektronikkomponenten zwischen diesen Schichten angeordnet sind.

Es besteht auch die Möglichkeit drei oder mehr Schichten mit dazwischenliegenden Leiterbahnen und/oder Elektronikkomponenten zu einer Membran zusammenzufassen. Vorteilhaft bei dieser Ausführungsform ist, dass verschiedene Stromkreise übereinander angeordnet werden können, ohne sich gegenseitig negativ zu beeinflussen. Die Schichten können dabei aus dem selben Material sein, die Schichten können auch aus unterschiedlichen Materialien sein. Es besteht auch die Möglichkeit an einer Außenseite, und an einer Innenseite und, bei zwei oder mehr Schichten auch dazwischenliegend Leiterbahnen und/oder Elektronikkomponenten anzubringen.

Gemäß einer weiteren Ausführungsform der Erfindung umfasst der Schritt des Anbringens der Leiterbahnen und Elektronikkomponenten ein additives Verfahren.

Beispiele für additive Fertigungsverfahren sind Massendruckverfahren wie der Tief-, Offset- und Flexodruck, welche sich im Vergleich mit anderen Druckverfahren vor allem durch eine weit überlegene Produktivität auszeichnet, die einen Flächendurchsatz von vielen 10.000 m²/h ermöglicht. Voraussetzung für ein additives Fertigungsverfahren ist dabei, neben der jeweiligen elektronischen Funktionalität, dass die Materialien in flüssiger Form, d. h. als Lösung, Dispersion oder Suspension, vorliegen. Analog zum konventionellen Bilderdruck, bei dem mehrere Farbschichten übereinander aufgetragen werden, werden dabei elektronische Dünnschicht-Bauelemente wie die erfindungsgemäßen Leiterbahnen und Elektronikkomponenten durch das Übereinanderdrucken mehrerer Funktionsschichten hergestellt. Weitere additive Fertigungsverfahren sind beispielweise der Tintenstrahldruck, der Siebdruck oder die Nanoprägelithografie.

Gemäß einer weiteren Ausführungsform der Erfindung umfasst der Schritt des Anbringens der Leiterbahnen und Elektronikkomponenten ein subtraktives Verfahren. Beispiele für subtraktive Verfahren sind dabei das Aufbringen von Ätzmasken oder das Lift-Off-Verfahren.

Die beiden Verfahrensarten, additive Verfahren und subtraktive Verfahren sind miteinander kombinierbar.

Gemäß einer weiteren Ausführungsform der Erfindung umfasst die Membran ein thermoplastisches Polymer. Thermoplastische Polymere sind Kunststoffe, die sich in einem bestimmten Temperaturbereich verformen lassen. Dieser Vorgang ist reversibel, das heißt, er kann durch Abkühlung und Wiedererwärmung bis in den schmelzflüssigen Zustand beliebig oft wiederholt werden, solange nicht durch Überhitzung die sogenannte thermische Zersetzung des Materials einsetzt.

Der thermoplastische Kunststoff der Membran umfasst dabei insbesondere Polyvinylfluiorid. Polyvinylfluorid ist schmutzabweisend sowie gut zu reinigen, und eignet sich daher besonders für die Anwendung als Schutzfolie.

Gemäß einer weiteren Ausführungsform der Erfindung umfasst der Schritt des Verbindens der Membran auf den Paneelkörper das Vorsehen einer Adhäsionsschicht

Die Adhäsionsschicht kann dabei jeden Prozesswerkstoff umfassen, der in der Lage ist, eine Oberflächenhaftung zwischen der Membran und dem Paneelkörper auszubilden.

Gemäß einer weiteren Ausführungsform der Erfindung ist die Adhäsionsschicht in die Membran integriert.

Die Adhäsionsschicht kann dabei die mit dem Paneelkörper zu kontaktierende Fläche der Membran vollständig bedecken, oder aber entlang der Leiterbahnen und/oder Elektronikkomponenten Aussparungen aufweisen.

Gemäß einer weiteren Ausführungsform der Erfindung weist der Paneelkörper auf der der Membran zugewandten Seite eine Schicht aus in Phenolharz getränktem glasfaserverstärktem Kunststoff auf.

Gemäß einer weiteren Ausführungsform der Erfindung ist eine erste Leiterbahn und eine zweite Leiterbahn über eine Überbrückungsvorrichtung miteinander verbunden. Die Überbrückungsvorrichtung weist dabei einen Abstand zu der Membran auf, und bildet dadurch einen Spalt aus. Unterhalb der Überbrückungsvorrichtung ist dadurch eine dritte Leiterbahn durch den entstandenen Spalt anordenbar, wobei die dritte Leiterbahn nicht in Kontakt zu erster und zweiter Leiterbahn steht.

Durch die Überbrückungsvorrichtung sind neben einem Mehrschicht-Ansatz mit einer jeweiligen Isolierschicht auch ein Einschicht-Ansatz umsetzbar. Die Überbrückungsvorrichtung dient dabei als Brücke über eine nicht zu kontaktierende Leiterbahn und ermöglicht dadurch eine sehr dünne Bauweise mit hoher Gewichtsersparnis, wobei insbesondere Kreuzungen ohne Kurzschluss realisiert werden können.

Gemäß einer weiteren Ausführungsform der Erfindung umfasst die Elektronikkomponente einen Sensor, ausgewählt aus der Gruppe Temperatursensor, Rauchmelder, Gassensor, Berührungssensor und Näherungssensor. Es sind aber auch andere Sensoren denkbar.

Da Sensoren in der Regel nur sehr geringe Ströme benötigen sind auch geringe Querschnitte der Leiterbahnen möglich. Für Anwendungsfälle mit höheren Strömen können auch größere Querschnitte, wie beispielsweise durch das Auflaminieren von Kupfer, angewendet werden. Insofern es sich bei dem Sensor um einen Berührungssensor handelt, kann der Berührungssensor auch Teil eines Touchpads sein.

Gemäß einer weiteren Ausführungsform der Erfindung, umfasst die Elektronikkomponente eine Licht emittierende Diode oder ein akustischer Emitter. Die licht emittierende Diode kann dabei eingerichtet sein einen Bereich auszuleuchten, oder um ein visuelles Signal im Dunkeln oder bei geringer Helligkeit anzuzeigen. Der akustische Emitter kann dabei eingerichtet sein, einem Benutzer einen Signalton zu übermitteln, oder als Lautsprecher zu dienen.

Gemäß einer weiteren Ausführungsform der Erfindung weisen die Leiterbahnen und die Elektronikkomponenten bevorzugt eine maximale Dicke von 20 µm, besonders bevorzugt eine maximale Dicke von 15 µm auf.

Gemäß einer weiteren Ausführungsform der Erfindung ist die Membran eine Dekorfolie.

Die Dekorfolie ist dabei kratzunempfindlich und widerstandsfähig gegenüber mechanischen Einflüssen. Ferner ist die Dekorfolie undurchlässig gegenüber Fetten und Ölen und diffusionsfest gegenüber Gasen.

Gemäß einem weiteren Aspekt der Erfindung ist eine Seitenwand eines Innenraums eines Luftfahrzeugs, umfassend ein Paneel, hergestellt nach einem erfindungsgemäßen Verfahren, insbesondere ein Fußbodenpaneel, ein Deckenpaneel, ein Seitenpaneel oder ein Gepäckablagepaneel, angegeben. Die Seitenwände sind dabei im Passagierbereich, im Cockpit oder im Frachtbereich einsetzbar. Es sind aber auch andere Bereiche denkbar.

Gemäß einem weiteren Aspekt der Erfindung ist ein Luftfahrzeug umfassend einer erfindungsgemäßen Seitenwand angegeben. Das Luftfahrzeug kann dabei ein Passagierflugzeug, ein Frachtflugzeug, ein Hubschrauber oder eine Drohne sein.

### Kurze Beschreibung der Figuren

Im Folgenden werden mit Verweis auf die Figuren Ausführungsbeispiele der Erfindung beschrieben. Darin zeigen:
Fig. 1 ein Ablaufdiagramm des Verfahrens gemäß einem Ausführungsbeispiel der Erfindung.
Fig. 2 ein Paneel gemäß einem weiteren Ausführungsbeispiel der Erfindung, wobei die Membran noch nicht vollständig mit dem Paneelkörper verbunden ist.
Fig. 3 eine Membran mit integrierten Leiterbahnen, einer Elektronikkomponente und einer Überbrückungsvorrichtung, gemäß einem weiteren Ausführungsbeispiel der Erfindung.
Fig. 4 eine Seitenwand eines Innenraums eines Luftfahrzeugs gemäß einem weiteren Ausführungsbeispiel der Erfindung.
Fig.5 ein Luftfahrzeug umfassend eine Seitenwand gemäß einem weiteren Ausführungsbeispiel der Erfindung.

### Detaillierte Beschreibung von Ausführungsbeispielen

Die Darstellungen in den Figuren sind schematisch und nicht maßstabsgetreu.

Werden in der folgenden Figurenbeschreibung gleiche Bezugsziffern verwendet, so betreffen diese gleiche oder ähnliche Elemente.

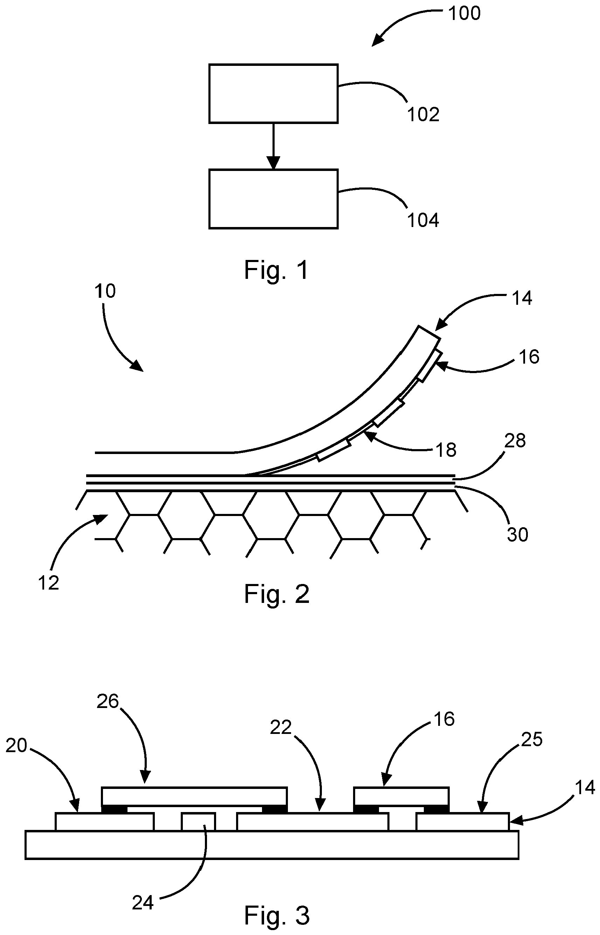

Fig. 1 zeigt ein Ablaufdiagramm des Verfahrens 100 gemäß einem Ausführungsbeispiel der Erfindung. Das Verfahren 100 dient der Herstellung eines Paneels 10 mit integrierten Leiterbahnen 18 und Elektronikkomponenten 16, wobei das Paneel 10 und dessen einzelne Komponenten in Fig. 2 genauer gezeigt, und in der Figurenbeschreibung von Fig. 2 beschrieben sind. Das Paneel 10 umfasst dabei einen Paneelkörper 12, wobei der Paneelkörper 12 insbesondere eine Sandwichstruktur umfasst. Ferner umfasst das Paneel 10 eine Membran 14. Die Membran 14 ist dabei mit dem Paneelkörper 12 verbunden und weist integrierte Leiterbahnen 18 und Elektronikkomponenten 16 auf.

Das Verfahren 100 ist dabei in folgende Schritte gegliedert. Zu Beginn des Verfahrens ist ein Anbringen 102 der Leiterbahnen 18 und der Elektronikkomponenten 16 auf die Membran 14 vorgesehen. Der darauffolgende Schritt umfasst ein Verbinden 104 der mit den Leiterbahnen 18 und den Elektronikkomponenten 16 bestückten Membran 14 mit dem Paneelkörper 12.

Fig. 2 zeigt einen detaillierten Aufbau eines erfindungsgemäßen Paneels 10. Das Paneel 10 weist dabei einen Paneelkörper 12 auf, welcher in der vorliegenden Ausführungsform aus einer Sandwichstruktur hergestellt ist. Auf dem Paneelkörper 12 ist eine, mit Phenolharz getränkte Schicht 30 aus glasfaserverstärktem Kunststoff vorgesehen. Um die Membran 14 mit dem Paneelkörper zu verbinden ist ferner eine Adhäsionsschicht 28 vorgesehen. Im gezeigten Ausführungsbeispiel sind auf der Membran auf der dem Paneelkörper 12 zugewandten Seite Leiterbahnen 18 und Elektronikkomponenten 16 angebracht. In Fig. 2 sind die Leiterbahnen 18 und Elektronikkomponenten zur besseren Übersichtlichkeit lediglich auf dem von dem Paneelkörper 12 beabstandeten Teil der Membran 14 gezeigt, der Fachmann wird allerdings erkennen, dass die Leiterbahnen 18 und Elektronikkomponenten 16 auch in dem Bereich vorhanden sind, in dem die Membran 14 mit dem Paneelkörper 12 verbunden ist.

Fig. 3 zeigt eine Membran 14 mit integrierten Leiterbahnen 18, einer Elektronikkomponente 16 und einer Überbrückungsvorrichtung 26, gemäß einem weiteren Ausführungsbeispiel der Erfindung. Gezeigt sind dabei eine erste Leiterbahn 20 und eine zweite Leiterbahn 22, wobei die erste Leiterbahn 20 mit der zweiten Leiterbahn 22 über eine Überbrückungsvorrichtung 26 verbunden sind. Die Überbrückungsvorrichtung 26 weist dabei einen Abstand zu der Membran 14 auf, und bildet somit einen Spalt aus. Unterhalb der Überbrückungsvorrichtung 26 ist eine dritte Leiterbahn 24 angeordnet, wobei die dritte Leiterbahn durch den entstandenen Spalt verläuft und mit der ersten Leiterbahn 20 und der zweiten Leiterbahn 22 nicht in Kontakt steht.

Weiterhin ist eine Elektronikkomponente 16 gezeigt. Die Elektronikkomponente 16 ist dabei mit der dritten Leiterbahn 24 und einer vierten Leiterbahn 25 verbunden. Es soll verstanden werden, dass Fig. 3 nur exemplarisch einen Ausschnitt einer Vielzahl von Möglichkeiten zeigt, die Elektronik auf die Membran anzubringen, und weitere Kombinationen denkbar sind.

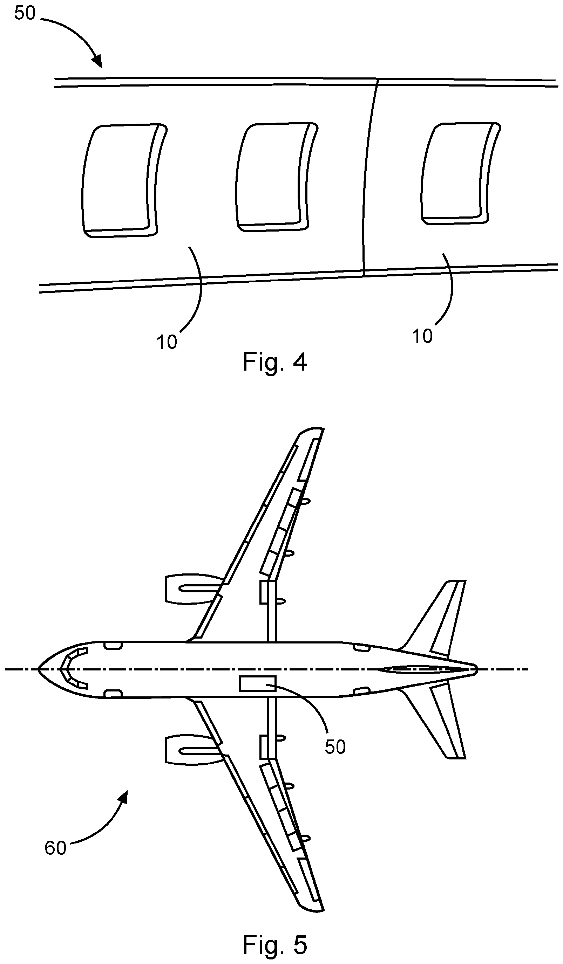

Fig. 4 zeigt eine Seitenwand 50 eines Luftfahrzeugs, gemäß einem weiteren Ausführungsbeispiel der Erfindung. In dem vorliegenden Ausführungsbeispiel ist die Seitenwand mit einem Seitenpaneel mit Aussparungen für Fenster verkleidet, wobei das Seitenpaneel ein Paneel 10, hergestellt mit dem erfindungsgemäßen Verfahren 100, ist. Exemplarisch sind zwei Paneele 10 gezeigt, wobei die Paneele über die komplette Länge des Innenraums des Luftfahrzeugs angebracht sein können (nicht gezeigt).

Fig. 5 zeigt ein Luftfahrzeug 60 mit einer Seitenwand 50 gemäß einem weiteren Ausführungsbeispiel der Erfindung. Die Seitenwand 50 ist dabei exemplarisch im Rumpfbereich des Luftfahrzeugs 60 angeordnet, es ist jedoch ohne Einschränkungen denkbar die Seitenwand 50 im Cockpit oder im Heckbereich anzuordnen. Die Seitenwand kann dabei auch ein Fußbodenpaneel, ein Deckenpaneel oder eine Gepäckablagepaneel sein.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### Liste der Bezugszeichen

- 10: Paneel
- 12: Paneelkörper
- 14: Membran
- 16: Elektronikkomponente
- 18: Leiterbahn
- 20: erste Leiterbahn
- 22: zweite Leiterbahn
- 24: dritte Leiterbahn
- 25: vierte Leiterbahn
- 26: Überbrückungsvorrichtung
- 28: Adhäsionsschicht
- 30: Schicht aus in Phenolharz getränktem glasfaserverstärktem Kunststoff
- 50: Seitenwand
- 60: Luftfahrzeug

## Patentansprüche

1. Ein Verfahren (100) zur Herstellung eines Paneels (10) mit integrierten Leiterbahnen (18) und Elektronikkomponenten (16),
wobei das Paneel (10) umfasst:
- einen Paneelkörper (12), wobei der Paneelkörper (12) insbesondere eine Sandwichstruktur umfasst; und
- eine Membran (14), wobei die Membran (14) mit dem Paneelkörper (12) verbunden ist, und wobei die Membran (14) integrierte Leiterbahnen (18) und Elektronikkomponenten (16) aufweist,
wobei das Verfahren (100) folgende Schritte aufweist:
- Anbringen (102) der Leiterbahnen (18) und der Elektronikkomponenten (16) auf die Membran (14),
- Verbinden (104) der Membran (14) mit dem Paneelkörper (12).

2. Das Verfahren (100) nach Anspruch 1,
wobei die integrierten Leiterbahnen (18) und Elektronikkomponenten (16) angebracht sind auf:
einer Innenseite der Membran (14), und/oder
einer Außenseite der Membran (14), und/oder
innerhalb der Membran (14).

3. Das Verfahren (100) nach einem der vorhergehenden Ansprüche,
wobei der Schritt des Anbringens der Leiterbahnen (18) und Elektronikkomponenten (18) ein additives Verfahren umfasst.

4. Das Verfahren (100) nach einem der vorhergehenden Ansprüche,
wobei der Schritt des Anbringens der Leiterbahnen und Elektronikkomponenten ein subtraktives Verfahren umfasst.

5. Das Verfahren (100) nach einem der vorhergehenden Ansprüche,
wobei die Membran (14) ein thermoplastisches Polymer, insbesondere Polyvinylfluorid, umfasst.

6. Das Verfahren (100) nach einem der vorhergehenden Ansprüche,
wobei der Schritt des Verbindens der Membran (14) mit dem Paneelkörper (12) über das Vorsehen einer Adhäsionsschicht (28) ausgeführt wird.

7. Das Verfahren (100) nach einem der vorhergehenden Ansprüche, wobei die Adhäsionsschicht (28) in die Membran (14) integriert ist.

8. Das Verfahren (100) nach einem der vorhergehenden Ansprüche,
wobei der Paneelkörper auf der der Membran (14) zugewandten Seite eine Schicht (30) aus in Phenolharz getränktem glasfaserverstärktem Kunststoff aufweist.

9. Das Verfahren (100) nach einem der vorhergehenden Ansprüche,
wobei eine erste Leiterbahn (20) und eine zweite Leiterbahn (22) über eine Überbrückungsvorrichtung (26) verbindbar sind, wobei die Überbrückungsvorrichtung (26) einen Abstand zu der Membran (14) aufweist, und dadurch einen Spalt ausbildet, sodass unterhalb der Überbrückungsvorrichtung (26) eine dritte Leiterbahn (24) durch den entstandenen Spalt, ohne Kontakt zu erster Leiterbahn (20) und zweiter Leiterbahn (22), anordenbar ist.

10. Das Verfahren (100) nach einem der vorhergehenden Ansprüche,
wobei die Elektronikkomponente (16) einen Sensor umfasst, ausgewählt aus der Gruppe Temperatursensor, Rauchmelder, Gassensor, Berührungssensor und Näherungssensor.

11. Das Verfahren (100) nach einem der vorhergehenden Ansprüche,
wobei die Elektronikkomponente (16) eine Licht emittierende Diode oder ein akustischer Emitter ist.

12. Das Verfahren (100) nach einem der vorhergehenden Ansprüche,
wobei die Leiterbahnen (18) und die Elektronikkomponenten (16) bevorzugt eine maximale Dicke von 20 µm, und besonders bevorzugt eine maximale Dicke von 15 µm aufweisen.

13. Das Verfahren (100) nach einem der vorhergehenden Ansprüche,
wobei die Membran (14) eine kratzunempfindliche Dekorfolie ist.

14. Eine Seitenwand (50) eines Innenraums eines Luftfahrzeugs, umfassend ein Paneel (10), hergestellt nach einem Verfahren nach einem der Ansprüche 1 bis 13, wobei das Paneel (10) insbesondere ein Fußbodenpaneel, ein Deckenpaneel, ein Seitenpaneel oder ein Gepäckablagepaneel ist.

15. Ein Luftfahrzeug (60), umfassend eine Seitenwand (50) nach Anspruch 14.
